# EUROPÄISCHE PATENTANMELDUNG

(11) **EP 2 146 375 A1**
(43) Veröffentlichungstag der Anmeldung: **20.01.2010**
(21) Anmeldenummer: 09008705.7
(22) Anmeldetag: 03.07.2009
(51) Int. Cl.: H01L 23/62, H01L 23/495, H01L 25/07

(54) **Halbleitermodul**

(30) Priorität: 16.07.2008 DE 102008040480
(71) Anmelder: Semikron Elektronik GmbH & Co. KG Patentabteilung, 90431 Nürnberg (DE)
(72) Erfinder: Königsmann, Günter, 91058 Erlangen-Tennenlohe (DE); Schreiber, Dejan, 90408 Nürnberg (DE); Mühlhofer, Alexander, 90522 Oberasbach (DE); Nascimento, Jair Do, 91077 Dormitz (DE)

(57) **Zusammenfassung**

Ein Halbleitermodul (2) enthält einen, einen von außen unzugänglichen Schaltanschluss (G) aufweisenden Leistungshalbleiter (6), eine von außen zugängliche Anschlussklemme (8), und einen einen vorgebbaren ohmschen Widerstand (R) aufweisenden und einen Bonddraht (18) enthaltenden Strompfad (22) zwischen Schaltanschluss (G) und Anschlussklemme (8), wobei der Bonddraht (18) ein Widerstandsdraht ist, der den vorgebbaren Widerstand (R) aufweist.

## Beschreibung

Die Erfindung betrifft ein Halbleitermodul.

In vielen Bereichen der Leistungselektronik wie z.B. in Halbleiterschaltern, Umrichtern oder Motorsteuerungen werden heute Leistungshalbleiter eingesetzt. Derartige Leistungshalbleiter werden in der Regel nicht als isoliertes Einzelbauteil gehandhabt, sondern in Form eines Halbleitermoduls, welches den eigentlichen Leistungshalbleiter beinhaltet. Ein derartiges Halbleitermodul besitzt z.B. geeignete Anschlussklemmen zur Verdrahtung des Leistungshalbleiters und ein Schutzgehäuse.

Viele Halbleitermodule beinhalten hierbei nicht nur einen, sondern mehrere Leistungshalbleiter, z.B. mehrere parallel geschaltete IGBTs. Jeder Leistungshalbleiter weist hierbei eigene Schaltanschlüsse z.B. einen Gatekontakt auf, die elektrisch zu kontaktieren sind. Da sich der Leistungshalbleiter innerhalb des Halbleitermoduls befindet und z.B. darin vergossen ist, sind die Schaltanschlüsse außerhalb des Halbleitermoduls in der Regel unzugänglich. Der entsprechende Schaltanschluss ist daher innerhalb des Moduls durch einen Strompfad auf eine externe Anschlussklemme des Halbleitermoduls geführt, welche also von außen zugänglich ist.

Beispielsweise IGBTs müssen im Regelfall mit einer Begrenzung ihrer Gateströme angesteuert werden. Das Bauteil, welches die Gateströme begrenzt, ist beispielsweise eine Stromquelle oder ein Gatewiderstand. Werden z.B. in einem Halbleitermodul mehrere IGBTs parallel geschaltet, so ist es in der Regel von Vorteil, die Gates einzelner IGBTs parallel zu schalten. Hierbei ist jedoch eine möglichst gute Entkopplung der einzelnen Gates voneinander notwendig. Bekannt ist, jedem Leistungshalbleiter bzw. dessen Gate einen kleinen bzw. individuellen ohmschen Gatewiderstand vorzuschalten. Die Halbleitermodule werden hierbei von einem externen, z.B. auf dem Halbleitermodul als Huckepack-Platine montierten Treiber angesteuert, welcher die zugängliche Anschlussklemme des Halbleitermoduls bedient. In der Regel ist dann zusätzlich außerhalb des Halbleitermoduls nochmals ein eigentlicher, größerer, auf der Treiberplatine angeordneter Gatewiderstand vorgeschaltet.

Nachteilig bei der bekannten Lösung ist, dass die individuellen Widerstände je nach Ausführung eigene Bauteile sind und als solche kontaktiert werden müssen. Dies verursacht erhebliche Kosten. Hierfür geeignet sind z.B. Chipwiderständen. Diese besitzen jedoch hohe parasitäre Kapazitäten, die die Einkopplung hochfrequenter Störungen in die Gates der einzelnen Leistungshalbleiter ermöglichen.

Ein weiterer Nachteil der einzelnen Widerstände ist, dass diese während des Schaltvorgangs am IGBT eine hohe Verlustleistung verkraften müssen. Die betreffenden Bauteile befinden sich aber bei konventionellem Aufbau eines Halbleitermoduls entfernt vom eigentlichen Leistungshalbleiter auf der Treiberplatine und werden so nicht vom in der Regel vorhandenen Kühlkörper des Halbleitermoduls mit erfasst, also nicht mitgekühlt. Für eine bessere Kühlleistung muss daher der Abstand zwischen den Gatewiderständen und damit die Treiberplatine vergrößert werden. Hieraus folgt für jedes Halbleitermodul, dass stets ein Kompromiss zwischen den Ausmaßen des zugehörigen Treibers, dessen Zuverlässigkeit und den Kosten innovativer Kühlungsmethoden oder Bauteiltechnologien gesucht werden muss.

Werden an einem o.g. Treiber außerdem mehrere Halbleitermodule parallelisiert, sind kostenintensive und platzraubende Schutzmaßnahmen notwendig. Diese müssen nämlich verhindern, dass ein Kurzschluss eines defekten Leistungshalbleiters das betreffende Modul selbst und z.B. über die am Halbleitermodul anliegende Zwischenkreisspannung auch die parallelisierten anderen Halbleitermodule zerstört.

Aufgabe der vorliegenden Erfindung ist es, ein verbessertes Halbleitermodul anzugeben.

Die Aufgabe wird gelöst durch ein Halbleitermodul, welches mindestens einen Leistungshalbleiter enthält. Der Leistungshalbleiter weist hierbei mindestens einen Schaltanschluss auf, welcher von außen, also von außerhalb des Halbleitermoduls, unzugänglich ist. Das Halbleitermodul enthält weiterhin mindestens eine von außen zugängliche Anschlussklemme. Zwischen Anschlussklemme und Schaltanschluss befindet sich ein Strompfad, welcher einen vorgebbaren ohmschen Widerstand aufweist und außerdem einen den Chip des Leistungshalbleiters mit dem Modul verbindenden Bonddraht enthält. Der Strompfad verläuft also zumindest auf einem Teilabschnitt über den Bonddraht. Erfindungsgemäß ist der Bonddraht ein Widerstandsdraht, wobei der Widerstandsdraht zumindest annähernd den vorgebbaren Widerstand aufweist. Mit anderen Worten ist der Widerstandsdraht das den vorgebbaren ohmschen Widerstand maßgeblich beeinflussende ohmsche Widerstandselement im Strompfad. Der restliche Widerstand im Strompfad rührt z.B. von parasitären Widerständen von Leitungen, Bauelementen o.ä. her. Eine Kombination mit einem weiteren Festwiderstand im Strompfad ist natürlich auch möglich. Erfindungsgemäß wird also der jeweilige Strompfad zum Leistungshalbleiter bzw. dem entsprechenden Halbleiterchip mit einem Widerstandsdraht anstelle eines normalen Bonddrahtes gebondet und dieser gleich als definierter ohmscher Widerstand genutzt.

Hierdurch ergeben sich verschiedene Vorteile, wie z.B. eine Optimierung der Systemkosten, da eine Bondverbindung ohnehin nötig ist und durch die Integration des Widerstandes in den Bonddraht keine weiteren individuellen Widerstandsbauteile in den Strompfaden mehr notwendig sind. Da nun der Bonddraht den Widerstand bildet und dieser sich aufgrund von Verlustleistung erwärmt, erfolgt gegenüber herkömmlichen, anderenorts plazierten Widerständen eine Verschiebung der Verlustleistung innerhalb des Halbleitermoduls zum Leistungshalbleiter hin. Die am Widerstandsdraht abfallende Verlustleistung kann dann in der Regel über den Kühlkörper des Leistungshalbleiters mit abgeführt werden, was zu einer effektiveren Kühlung führt.

Im Falle mehrerer Leistungshalbleiter wird die Ansteuerung dieser optimiert, da die o.g. Entkopplung durch die Gatewiderstände nun direkt auf Modulebene, d.h. in jedem Halbleitermodul separat und nicht mehr auf Treiberebene stattfindet. Beschädigt wird also nur noch das isolierte Modul und nicht mehr der Treiber oder gar die parallelisierten Module.

Obschon ein Bonddraht sehr dünn ist, hat ein einzelner ohmscher Widerstand für eine einzelne Anschlussklemme innerhalb eines Halbleitermoduls nur relativ wenig an Verlustleistung zu verkraften. Dank des geringen Durchmesser verfügt der Bonddraht jedoch über eine für seine Querschnittsfläche relativ große Oberfläche, an welcher der Widerstandsdraht und damit der Widerstand gekühlt wird.

In einer vorteilhaften Ausführungsform der Erfindung enthält das Halbleitermodul mehrere Leistungshalbleiter, wobei jeder Leistungshalbleiter jeweils mindestens eine Anschlussklemme aufweist und wobei jede Anschlussklemme über einen eigenen Widerstandsdraht als Bonddraht mit einem oder mehreren Schaltanschlüssen verbunden ist. So kann jeder einzelnen Anschlussklemme ein individueller Widerstand als Vorwiderstand zugeordnet werden. Ein zusätzlicher Vorwiderstand außerhalb des Halbleitermoduls, beispielsweise im oben genannten Treiber, kann dann entfallen und das gesamte System aus Halbleitermodul und Treiber wird einfacher als bei Einsatz eines einzigen, viel größeren Gatewiderstandes.

Im Falle mehrer separater Widerstandsdrähte als Bonddrähte können diese jeweils unterschiedliche Widerstandswerte aufweisen. Somit ist eine individuelle Anpassung der Widerstände als Vorwiderstände für jede einzelne Anschlussklemme bzw. Leistungshalbleiter innerhalb des Halbleitermoduls einfach möglich. Hier sind Widerstanddrähte verschiedener Länge, Durchmesser, spezifischer Widerstände o.ä. denkbar.

Da das Halbleitermodul in der Regel einen thermisch angekoppelten Kühlkörper aufweist, welcher z.B. einem Leistungshalbleiter bzw. einer diesen tragenden Grundplatte zugeordnet ist, kann der Widerstandsdraht thermisch mit dem Kühlkörper gekoppelt sein. Besonders einfach ist dies zu erreichen, wenn beispielsweise der Bonddraht im Halbleitermodul zusammen mit dem den Leistungshalbleiter tragenden Chip auf einer Grundplatte vergossen ist. Die oben genannte relativ große Oberfläche des Widerstandsdrahtes im Verhältnis zu dessen Querschnittsfläche wird dann durch die umschließende Gießmasse, welche ihrerseits über die Grundplatte in thermischer Kopplung mit dem Kühlkörper steht, besonders gut gekühlt.

In einer weiteren vorteilhaften Ausführungsform ist der Bonddraht so dimensioniert, dass dieser bei einem fehlerhaften Widerstandsabfall im zugehörigen Leistungshalbleiter durchbrennt, wenn die sonstigen Betriebsverhältnisse ansonsten regulär sind.

Hieraus ergibt sich folgender Vorteil: In einem Halbleitermodul kann ein Chipfehler auftreten, bei welchem ein Leistungshalbleiter derart zerstört wird, dass dessen Widerstand abfällt - z.B. dieser einen Kurzschluss bildet. Der Widerstandsdraht des betreffenden Leistungshalbleiters brennt dann in der Folge sicher durch. Somit wird der schadhafte Leistungshalbleiter im Halbleitermodul isoliert. Grund hierfür ist der relativ hochohmige Widerstand des Bonddrahtes, z.B. als Gatewiderstand bei einem IGBT-Chip, welcher daher bei einer bereits relativ geringen Leistung schon heiß wird. Für das Halbleitermodul ergibt sich, falls es sich z.B. um einen Single-Chip-Fehler in einem Mehrchip-Modul handelt, so fortan ein Fehlermodus oder Notlaufbetrieb, d.h. das Modul kann weiterfunktionieren, nur eben mit einem Chip bzw. Leistungshalbleiter weniger. Zu vermeiden ist hierbei lediglich, dass das beim Durchbrennen des Chips und des Widerstandsdrahtes entstehende Licht nicht benachbarte Leistungshalbleiter innerhalb des Halbleitermoduls zündet.

Wie bereits erwähnt, kann der Leistungshalbleiter ein IGBT und der Schaltanschluss das Gate des betreffenden IGBT sein. Besonders IGBTs werden heute häufig in Halbleitermodulen eingesetzt, so dass das erfindungsgemäße Halbleitermodul mit derartigen Bauteilen besonders wegen hoher Stückzahlen vorteilhaft ist.

Für eine weitere Beschreibung der Erfindung wird auf die Ausführungsbeispiele der Zeichnung verwiesen. Es zeigt, in einer schematischen Prinzipskizze:

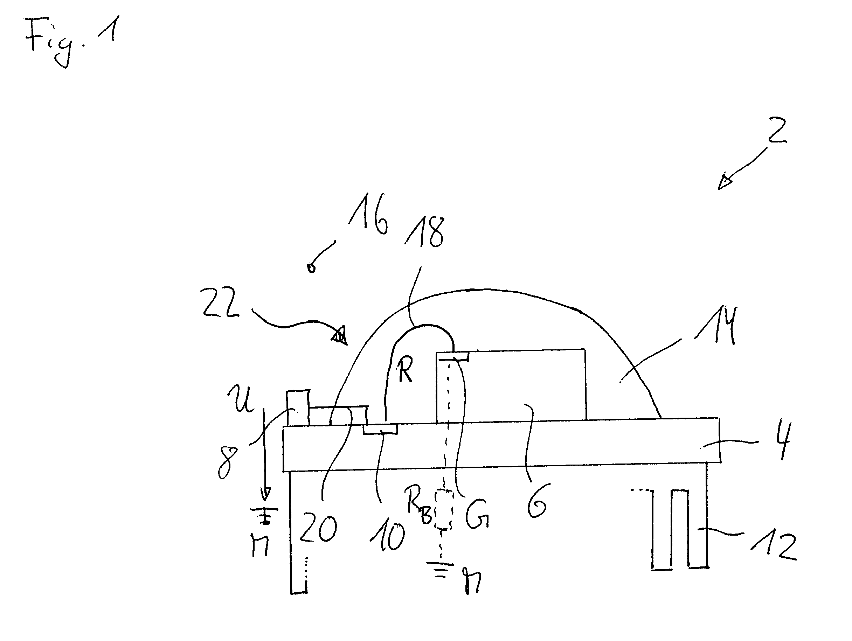

Fig. 1 ein erfindungsgemäßes Halbleitermodul.

Fig. 1 zeigt ein Halbleitermodul 2 im Schnitt, umfassend eine Grundplatte 4 auf welcher ein IGBT 6 als Leistungshalbleiter in Form eines Chips angebracht ist. Auf der Grundplatte 4 ist außerdem eine Anschlussklemme 8 sowie eine Kontaktierung 10 angebracht. Die Grundplatte ist auf einem Kühlkörper 12 montiert. Bis auf die Anschlussklemme 8 und den Kühlkörper 12 sind sämtliche genannten Bauteile durch Kunststoffmasse 14 miteinander vergossen bzw. eingeschlossen.

Wegen des vergossenen Aufbaus ist das Gate G des IGBT 6 vom Außenraum 16, also von außerhalb des Halbleitermoduls 2 nicht zugänglich. Mit anderen Worten ist das Gate G nicht durch eine elektrische Leitung mit einer nicht dargestellten Steuerschaltung außerhalb des Halbleitermoduls 2 verbindbar. Das Gate G ist daher mit der Kontaktierung 10 innerhalb der Kunststoffmasse 14 über einen Widerstandsdraht 18 verbunden. Da es sich um eine Chipkontaktierung handelt, ist dies eine Bondverbindung, d.h. der Widerstandsdraht 18 ist ein Bonddraht.

Die Kontaktierung 10 wiederum ist über einen weiteren Leiter 20 mit der Anschlussklemme 8 verbunden, welche vom Außenraum 16 zugänglich ist. Somit ist von der Anschlussklemme 8 über den Leiter 20, die Kontaktierung 10 und den Widerstandsdraht 18 ein elektrisch leitender Strompfad 22 zum Gate G hergestellt.

Der Widerstandsdraht 18 wurde gezielt so gewählt, dass dieser den ohmschen Widerstand R aufweist. Da die restlichen Elemente im Strompfad 22 nahezu vernachlässigbaren ohmschen Widerstand aufweisen, besitzt auch der gesamte Strompfad 22 den ohmschen Widerstand R. Der Strompfad 22 bzw. der Widerstanddraht 18 bildet somit den gewünschten Gatewiderstand für das Gate G des IGBT 6. Die am Widerstandsdraht 18 im Betrieb entstehende Verlustwärme wird über die umgebende Kunststoffmasse 14 bzw. den IGBT 4 und die Grundplatte 4 zum Kühlkörper 12 und über diesen an den Außenraum 16 abgeleitet.

Im regulären Betrieb, d.h. bei Anlegen einer Schaltspannung U zwischen Anschlussklemme 8 und Masse M weist der IGBT 6 einen Widerstand R_{B} zwischen seinem Gate G und der Masse M auf.

In einem alternativen Betriebsfall unterliegt der IGBT 6 einem fehlerhaften Ausfall. Dessen Widerstand R_{B} sinkt auf nahezu Null, so dass fortan über das Gate G der Widerstandsdraht 18 bezüglich der Schaltspannung U gegen Masse geführt ist. Die restlichen Verhältnisse in der Schaltung bleiben regulär, d.h. nahezu gleich: Da somit der Strom durch den Widerstandsdraht 18 stark zunimmt, führt zu dessen Durchbrennen und damit einer sauberen dauerhaften Trennung der Verbindung zwischen Kontaktierung 10 und Gate G. Fortan ist der IGBT 6 daher elektrisch von der Anschlussklemme 8 isoliert. Kriechströme etc, die die restliche, nicht dargestellte Schaltung belasten würden, sind vermieden.

In einer alternativen Ausführungsform sind weitere, nicht dargestellte IGBTs 6 auf der Grundplatte 4 montiert, die dem gezeigten IGBT6 parallel geschaltet, also an der Kontaktierung 10 angeschlossen sind. Durch Auftrennen des Widerstandsdrahtes 18 ist somit zwar der gezeigte als defekt angenommene IGBT 6 isoliert, die restlichen IGBTs 6 aber noch in Betrieb. Im Halbleitermodul 2 sinkt damit lediglich der höchstzulässige Laststrom durch die IGBTs 6 um den Laststrom des zerstörten IGBT 6, das Halbleitermodul 2 als solches bleibt allerdings funktionsfähig mit Notlaufeigenschaften.

## Patentansprüche

1. Halbleitermodul (2) mit einem, einen von außen unzugänglichen Schaltanschluss (G) aufweisenden Leistungshalbleiter (6), mit einer von außen zugänglichen Anschlussklemme (8), und mit einem einen vorgebbaren ohmschen Widerstand (R) aufweisenden und einen Bonddraht (18) enthaltenden Strompfad (22) zwischen Schaltanschluss (G) und Anschlussklemme (8), wobei der Bonddraht (18) ein Widerstandsdraht ist, der den vorgebbaren Widerstand (R) aufweist.

2. Halbleitermodul (2) nach Anspruch 1, mit mehreren Leistungshalbleitern (6) mit jeweils einer Anschlussklemme (G), wobei jede Anschlussklemme (8) über einen Widerstandsdraht als Bonddraht (18) mit dem Schaltanschluss (G) verbunden ist.

3. Halbleitermodul (G) nach Anspruch 2, bei dem die Bonddrähte (18) unterschiedliche Widerstände (R) aufweisen.

4. Halbleitermodul (2) nach einem der vorhergehenden Ansprüche, das einen Kühlkörper (12) aufweist, bei dem der Bonddraht (18) thermisch mit dem Kühlkörper (12) gekoppelt ist.

5. Halbleitermodul (2) nach einem der vorhergehenden Ansprüche, bei dem der Bonddraht (18) so dimensioniert (R) ist, dass dieser bei einem fehlerhaften Widerstandsabfall (R_{B}) im Leistungshalbleiter (6) bei ansonsten regulären Betriebsverhältnissen (U) durchbrennt.

6. Halbleitermodul (2) nach einem der vorhergehenden Ansprüche, bei dem der Leistungshalbleiter (6) ein IGBT und der Schaltanschluss (G) dessen Gate ist.
